Europäisches Patentamt

European Patent Office

Office européen des brevets

(19)

(11) Numéro de publication: **0 316 230**
**A1**

## (12) DEMANDE DE BREVET EUROPEEN

(21) Numéro de dépôt: 88402801.0

(22) Date de dépôt: 07.11.88

(51) Int. Cl.⁴: **H 01 L 29/28**

(30) Priorité: 09.11.87 FR 8715490

(43) Date de publication de la demande:
17.05.89 Bulletin 89/20

(84) Etats contractants désignés:
BE CH DE GB LI NL

(71) Demandeur: Clarisse, Christian
13, résidence de Pors-Ty-Olu Saint-Quay Perros
F-22700 Perros Guirec (FR)

Le Contellec, Michel
43, Résidence du Roux
F-22300 Lannion (FR)

Riou, Marie-Thérèse
Rue d'Estienne d'Orves
F-22700 Perros-Guirec (FR)

(72) Inventeur: Clarisse, Christian
13, résidence de Pors-Ty-Olu Saint-Quay Perros
F-22700 Perros Guirec (FR)

Le Contellec, Michel
43, Résidence du Roux
F-22300 Lannion (FR)

Riou, Marie-Thérèse
Rue d'Estienne d'Orves
F-22700 Perros-Guirec (FR)

(74) Mandataire: Martin, Jean-Jacques et al
Cabinet REGIMBEAU 26, Avenue Kléber
F-75116 Paris (FR)

(54) Dispositif à semiconducteur organique à base de phtalocyanine.

(57) La présente invention concerne un dispositif à semiconducteur organique à base de phtalocyanine. Selon l'invention le dispositif comprend, d'une part, un substrat composé d'une couche (10) d'un matériau conducteur recouverte d'une couche (20) d'un matériau diélectrique et, d'autre part, un revêtement déposé sur la couche de matériau diélectrique et composé d'un semiconducteur moléculaire extrinsèque (30) formé d'une monophtalocyanine d'un métal divalent ou d'une monophtalocyanine hydrogénée et d'un semiconducteur moléculaire intrinsèque (40) formé d'une phtalocyanine radicalaire.

FIG. 2

EP 0 316 230 A1

**Description**

## DISPOSITIF A SEMICONDUCTEUR ORGANIQUE A BASE DE PHTALOCYANINE

La présente invention concerne le domaine des dispositifs à semiconducteur organique réalisés à base de phtalocyanine.

De nombreuses recherches ont été conduites sur les propriétés électriques des phtalocyanines.

Des résultats de ces recherches sont par exemple indiqués dans les documents suivants : (1) Brevets JP 047 295, JP 047 296 et JP 047 297 du 9 mars 1985, (2)"Formation of MIS Structure in Organic Cell Al/Pb - Phtalocyanine/ITO" Kanayama et Al - Japanese Journal of Applied Physics - volume 22, N.2, février 1983 pages 348-350, (3) "Phtalocyanines electrolyte Schottky - junction devices" - Loufty et al -Can. J. Chem. volume 61, 1983 - pages 72-77, (4) "Molecular material based junctions : Formation of a Schottky contact with metallophtalo-cyanine thin films doped by the cosublimation method" - Maitrat et al -J. Applied Physics 60 ler octobre 1987, pages 2396-2400, (5) "Molecular semiconductors and junction formation : phtalocyanine derivatives", Andre et al - Synthetic Metals, 18, (1987) 683-688.

Ces documents montrent que dans certaines configurations et/ou moyennant certains dopages, les phtalocyanines possèdent des propriétés semiconductrices permettant de réaliser des dispositifs présentant des effets de diodes.

Cependant les dispositifs jusqu'ici proposés à base de phtalocyanine sont très instables à l'air, comme l'indique les documents précités. De plus, il s'est avéré jusqu'ici difficile d'obtenir des films minces et homogènes à base de phtalocyanine.

La présente invention a pour but d'éliminer les inconvénients de la technique antérieure et de proposer une structure apte à définir un dispositif à semiconducteur organique du type transistor.

Ces buts sont atteints, dans le cadre de la présente invention, grâce à un dispositif à semiconducteur comprenant :
- un substrat composé
. d'une couche d'un matériau conducteur recouverte
. d'une couche d'un matériau diélectrique, et
- un revêtement déposé sur la couche de matériau diélectrique et composé :
. d'un semiconducteur moléculaire extrinsèque formé d'une monophtalocyanine d'un métal divalent ou d'une monophtalocyanine hydrogénée, et
. d'un semiconducteur moléculaire intrinsèque formé d'une phtalocyanine radicalaire.

D'autres caractéristiques, buts et avantages de la présente invention apparaîtront à la lecture de la description détaillée qui va suivre, et en regard des dessins annexés, donnés à titre d'exemple non limitatif et sur lesquels :
- les 1A, 1B, 1C, 1D et 1E illustrent cinq étapes successives de fabrication d'un dispositif à semiconducteur conforme à la présente invention,
- la figure 2 représente une vue schématique en coupe du même dispositif, et
- les figures 3, 4, 5 et 6 illustrent des courbes relevées sur différents dispositifs à semiconducteur conformes à l'invention, du type transistor à effet de champ. Plus précisément les courbes 3 à 6 illustrent le courant passant entre le drain et la source du dispositif, en fonction de la tension entre le drain et la source, pour diverses tensions de grille.

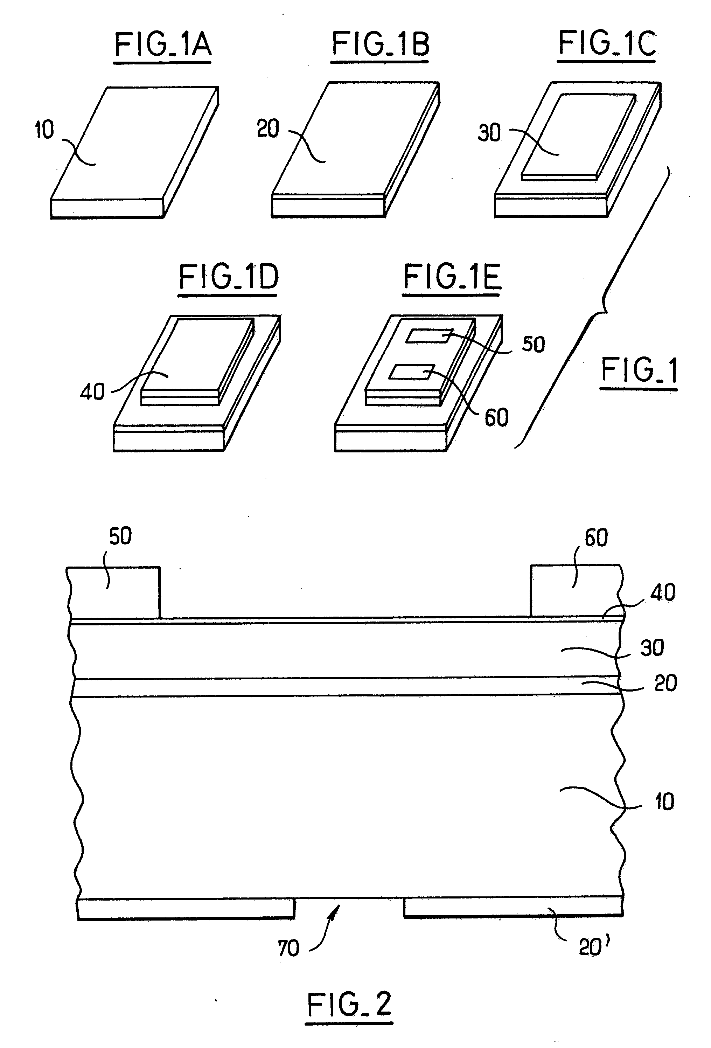

On aperçoit sur la figure 1A annexée une couche 10 d'un matériau conducteur du substrat. La couche 10 peut être formée par exemple de silicium dopé.

Comme illustré sur la figure 1B, la couche 10 doit être revêtue d'une couche d'un matériau diélectrique 20. La couche diélectrique 20 peut être obtenue, par exemple par oxydation du silicium composant la couche 10, afin d'obtenir une couche 20 de $SiO_2$.

La couche 20 de diélectrique possède avantageusement une épaisseur de l'ordre $1. 10^{-7}$ m.

En variante, la couche 10 peut être formée de silicium dopé et la couche diélectrique 20 de $Si_3N_4$.

Comme illustré sur les figures 1 C et 1 D, un revêtement est déposé sur la couche de matériau diélectrique 20. Le revêtement précité est composé d'un semiconducteur moléculaire extrinsèque 30 et d'un semiconducteur moléculaire intrinsèque 40 formé d'une phtalocyanine radicalaire.

Par phtalocyanine radicalaire, on entend une phtalocyanine formant spontanément donneur (et possédant par conséquent un électron libre) ou accepteur.

Dans le cadre de l'invention, le semiconducteur moléculaire extrinsèque 30 est formé d'une monophtalocyanine d'un métal divalent ou d'une monophtalocyanine hydrogénée.

Après de nombreux essais et recherches, les inventeurs ont déterminé que pour donner satisfaction en combinaison avec le semiconducteur moléculaire extrinsèque 30 formé d'une monophtalocyanine d'un métal divalent ou d'une monophtalocyanine hydrogénée, le semiconducteur moléculaire intrinsèque 40 formé d'une phtalocyanine radicalaire devait être formé soit d'une diphtalocyanine de terre rare, par exemple de lanthane ou de lutécium, soit d'une diphtalocyanine d'yttrium ou de scandium, soit d'une diphtalocyanine d'actinide, ou encore d'une phtalocyanine de lithium. Tous ces composés possèdent en effet spontanément des propriétés de semiconducteur moléculaire intrinsèque aptes à doper le matériau semiconducteur moléculaire extrinsèque 30 formé d'une monophtalocyanine d'un métal divalent ou d'une monophtalocyanine hydrogénée.

Dans le cadre de la présente invention, le revêtement composé d'un semiconducteur moléculaire extrinsèque 30 et d'un semiconducteur moléculaire intrinsèque 40 est déposé par évaporation sous vide sur la couche 20 de matériau diélectrique du substrat.

Le semiconducteur moléculaire extrinsèque 30 et le semiconducteur moléculaire intrinsèque 40 peuvent être déposés sur la couche de matériau diélectrique 20 du substrat, par cosublimation simultanée.

En variante, le semiconducteur extrinsèque 30 et le semiconducteur moléculaire intrinsèque 40 peuvent être déposés sur la couche de matériau diélectrique 20 du substrat par sublimations consécutives, le semiconducteur moléculaire extrinsèque étant de préférence évaporé en premier.

Dans le cas de sublimations consécutives du semiconducteur moléculaire extrinsèque 30 et du semiconducteur moléculaire intrinsèque 40, il est de préférence prévu ultérieurement une étape de recuit du dispositif pour favoriser la diffusion du semiconducteur moléculaire intrinsèque 40.

Comme illustré sur la figure 1E, deux plages séparées 50, 60 de matériau électriquement conducteur sont ensuite déposées sur le revêtement 40. Ces deux plages 50, 60 servent de source et de drain pour le dispositif. En parallèle, un contact 70 servant de grille est pris sur la couche de matériau conducteur 10 à l'opposé de la couche diélectrique 20.

Dans le cas où la couche diélectrique est formée par oxydation de la pastille 10, le contact 70 est réalisé sur la couche 10 après décapage local de la couche d'oxydation, comme illustré schématiquement sur la figure 2. De telles étapes de décapage et de métallisation sont classiques en soi et ne seront donc pas décrites plus en détail par la suite.

De préférence, la couche de semiconducteur extrinsèque formée d'une monophtalocyanine de métal divalent ou d'une monophtalocyanine hydrogénée possède une épaisseur comprise entre $1.10^{-7}m$ et $5.10^{-7}m$.

Les inventeurs ont constaté que le dispositif à semiconducteur organique précédemment défini et illustré sur les figures 1 et 2 présente un effet de champ lorsque la couche de semiconducteur moléculaire intrinsèque 40 formée d'une phtalocyanine radicalaire possède une épaisseur inférieure à $1.10^{-7}m$. En d'autres termes, lorsque la couche 40 possède une épaisseur inférieure à $1.10^{-7}m$, on constate que le courant traversant le dispositif entre le drain et la source 50, 60, croît exponentiellement avec la tension appliquée entre la source et le drain, le courant étant d'autant plus élevé que le potentiel appliqué à la grille 70 est plus faible.

Par contre, les inventeurs ont constaté que le dispositif à semiconducteur organique précédemment défini et illustré sur les figures 1 et 2 présente un comportement ohmique lorsque la couche de semiconducteur intrinsèque 40 formée d'une phtalocyanine radicalaire possède une épaisseur supérieure à $1.10^{-7}m$. En d'autres termes, lorsque la couche 40 possède une épaisseur supérieure à $1.10^{-7}m$, on constate que le courant traversant le dispositif entre le drain et la source 50, 60, croît linéairement avec la tension appliquée entre la source et le drain, le courant drain-source étant sensiblement indépendant du potentiel appliqué à la grille 70.

On va maintenant indiquer quatre exemples de réalisation de dispositif à semiconducteur organique conforme à la présente invention.

## EXEMPLE 1

Une rondelle de silicium 10 dopée N, dont la conductivité est $10^{2-1}cm^{-1}$ est oxydée thermiquement jusqu'à obtention d'une couche de silice possédant une épaisseur de l'ordre de $10^{-7}m$.

Sur la couche de silice 20 on dépose par évaporation sous vide une couche 30 de phtalocyanine de nickel possédant une épaisseur de l'ordre de $3.10^{-7}m$, avec une vitesse de dépôt de l'ordre de $3.10^{-10}m/s$.

Puis on dépose une couche de diphtalocyanine de scandium d'une épaisseur de l'ordre de $O,2.10^{-7}m$ à une vitesse de l'ordre de $2.10^{-10}m/s$.

Des contacts 50, 60, en or, servant de source et de drain sont ensuite réalisés sur la couche 40 de diphtalocyanine de scandium. Les contacts 50, 60 possèdent une épaisseur de l'ordre de $3.10^{-7}m$. Ils ont une surface de l'ordre de $150 \times 150.10^{-6}m$. L'intervalle entre deux contacts est de l'ordre de $50.10^{-6}m$. De préférence, les contacts 50, 60 servant de source et de drain sont réalisés par évaporation sous vide.

Un contact servant de grille 70 est pris sur le côté de la rondelle de silicium 10, opposé au dépôt des phtalocyanines 30, 40, par décapage chimique de la couche d'oxyde.

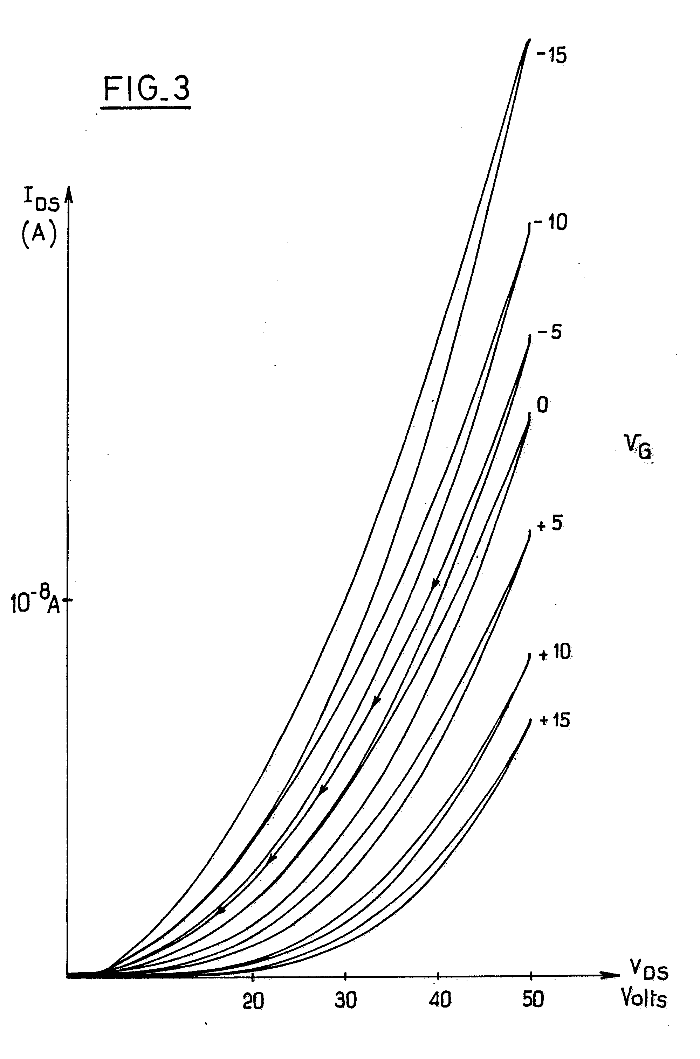

On a illustré sur la figure 3 la valeur du courant passant entre les contacts source et drain 50, 60, en fonction de la tension source-drain appliquée et pour différentes valeurs de tension grille. La figure 3 montre que le dispositif permet une modulation du courant. Il se comporte comme un transistor du type à effet de champ. En effet, le courant $I_{DS}$ passant entre les contacts source et drain 50, 60, croît exponentiellement avec la tension $V_{DS}$ appliquée entre la source et le drain, la valeur du courant étant par ailleurs d'autant plus élevée que le potentiel de grille $V_G$ est plus faible.

## EXEMPLE 2

De façon similaire à l'exemple 1 précité, une rondelle 10 de silicium dopée N est oxydée thermiquement jusqu'à obtention d'une couche de silice d'une épaisseur de l'ordre de $10^{-7}m$, puis une couche de phtalocyanine de nickel d'une épaisseur de l'ordre de $3.10^{-7}m$ est déposée par évaporation sous vide sur la couche de silice. Cependant, dans le cadre de l'exemple 2, la couche de diphtalocyanine de scandium déposée ultérieurement possède une épaisseur de l'ordre de $2.10^{-7}m$.

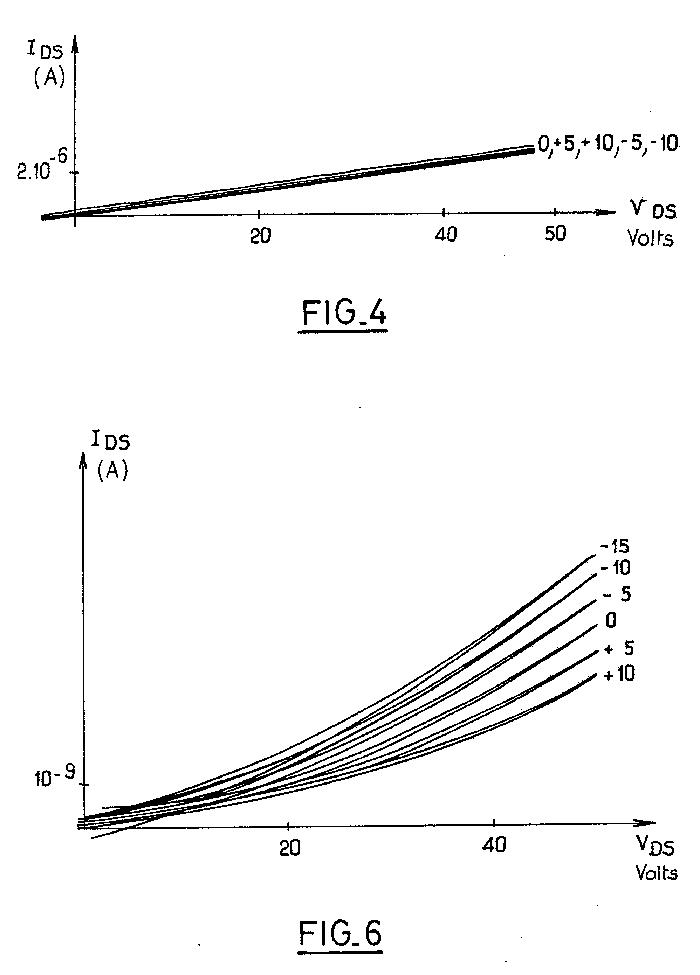

On a illustré sur la figure 4 la valeur du courant passant entre les contacts source et drain 50, 60, en fonction de la tension source-drain appliquée, et pour différentes valeurs de tension grille. La figure 4 montre que le dispositif, qui possède une épaisseur de semiconducteur moléculaire intrinsèque supérieure a $10^{-7}m$ présente un comportement ohmique. En effet, le courant $I_{DS}$ croît sensiblement linéairement avec la tension $V_{DS}$. Par ailleurs le courant $I_{DS}$ est pratiquement indépendant de la tension grille $V_G$.

On notera de plus que l'intensité du courant $I_{DS}$ délivré dans le cadre de l'exemple 2 est environ 100 fois plus élevée que dans le cadre de l'exemple 1.

## EXEMPLE 3

De façon similaire aux exemples 1 et 2, une rondelle 10 de silicium dopée N est oxydée thermiquement jusqu'à obtention d'une couche de silice 20 d'une épaisseur de l'ordre de $10^{-7}m$, puis une couche de phtalocyanine de nickel d'une épaisseur de l'ordre de $3.10^{-7}$m est déposée par évaporation sous vide sur la couche de silice.

Par la suite, une couche 40 de diphtalocyanine d'yttrium est déposée par évaporation sous vide sur la couche 30 de phtalocyanine de nickel, selon une épaisseur de l'ordre de $0,3.10^{-7}$m.

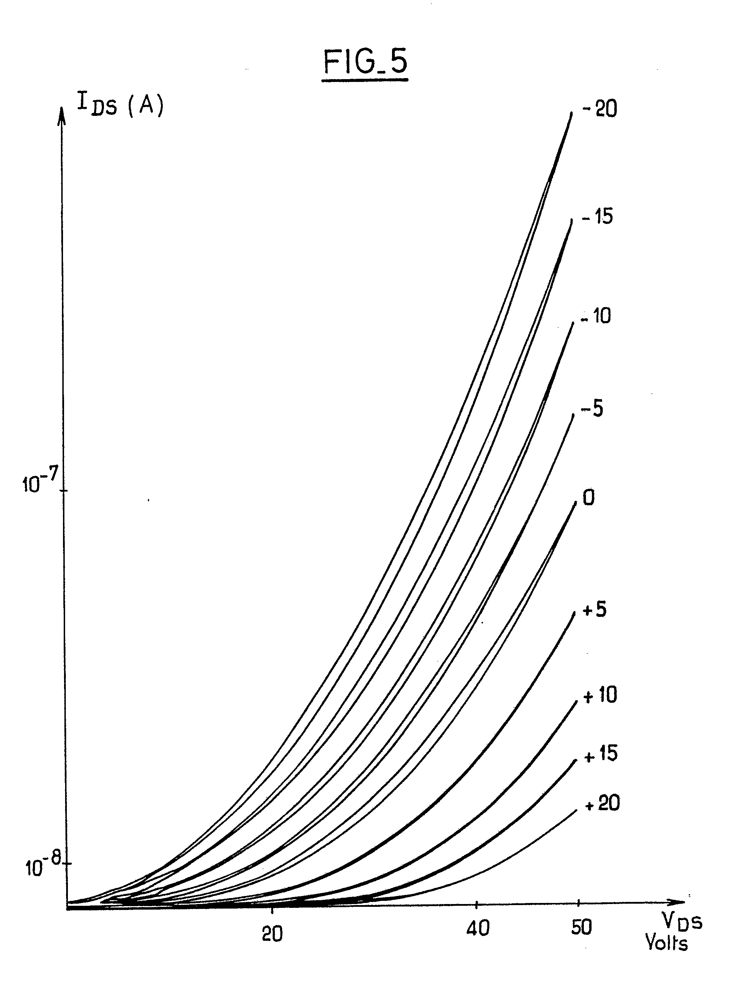

On a illustré sur la figure 5 la valeur du courant passant entre les contacts source et drain 50, 60, en fonction de la tension source-drain appliquée, pour différentes valeurs de tension grille $V_G$.

La figure 5 montre que le dispositif conforme à l'exemple 3 présente une modulation de courant et se comporte comme un transistor à effet de champ, comme dans le cadre de l'exemple 1.

## EXEMPLE 4

Une rondelle 10 de silice dopée N est oxydée thermiquement jusqu 'à obtention d'une couche de silice d'une épaisseur de l'ordre de $10^{-7}$m.

Une couche de phtalocyanine de zinc d'une épaisseur de l'ordre de $3.10^{-7}$m est déposée sur la couche de silice 20. Puis une couche de diphtalocyanine de lutécium d'une épaisseur de l'ordre de $0,3.10^{-7}$m est déposée sur la couche 30.

On a illustré sur la figure 6 la valeur du courant passant entre les contacts source et drain 50, 60 en fonction de la tension source-drain appliquée, pour différentes valeurs de la tension grille. La figure 6 montre que le dispositif permet une modulation du courant et se comporte comme à transistor à effet de champ, de façon similaire aux exemples 1 et 3 précités.

Le dispositif à semiconducteur organique conforme à la présente invention est susceptible d'être réalisé à base de toute phtalocyanine sublimable.

Bien entendu la présente invention n'est pas limitée au mode de réalisation particulier qui vient d'être décrit mais s'étend à toutes variantes conformes à son esprit.

On notera en particulier que la présente invention n'est pas limitée à la réalisation de transistor à effet de champ.

Elle s'étend également à la réalisation de résistances variables ou de dispositif à transfert de charge.

## Revendications

1. Dispositif à semiconducteur, caractérisé par le fait qu'il comprend :
- un substrat composé
. d'une couche (10) d'un matériau conducteur recouverte
. d'une couche (20) d'un matériau diélectrique, et
- un revêtement déposé sur la couche de matériau diélectrique et composé :
. d'un semiconducteur moléculaire extrinsèque (30) formé d'une monophtalocyanine d'un métal divalent ou d'une monophtalocyanine hydrogénée, et
. d'un semiconducteur moléculaire intrinsèque (40) formé d'une phtalocyanine radicalaire.

2. Dispositif selon la revendication 1, caractérisé par le fait que le semiconducteur moléculaire intrinsèque (40) formé d'un phtalocyanine radicalaire est une diphtalocyanine de terre rare.

3. Dispositif selon la revendication 1, caractérisé par le faitq que le semiconducteur moléculaire intrinsèque (40) formé d'une phtalocyanine radicalaire est une diphtalocyanine d'yttrium ou de scandium.

4. Dispositif selon la revendication 1, caractérisé par le fait que le semiconducteur moléculaire intrinsèque (40) formé d'une phatalocyanine radicalaire est une diphtalocyanine d'actinide.

5. Dispositif selon la revendication 1, caractérisé par le fait que le semiconducteur moléculaire intrinsèque (40) formé d'une phtalocyanine radicalaire est une phtalocyanine de lithium.

6. Dispositif selon l'une des revendications 1 à 5, caractérisé par le fait que le revêtement, composé d'une semiconducteur moléculaire extrinsèque (30) formé d'une monophtalocyanine d'un métal divalent ou d'une monophtalocyanine hydrogénée et d'un semiconducteur moléculaire intrinsèque (40) formé d'une phtalocyanine radicalaire, est déposé par évaporation sous vide sur la couche de matériau diélectrilque (20) du substrat.

7. Dispositif selon l'une des revendications 1 à 6, caractérisé par le fait que le revêtement (30, 40) est déposé sur la couche de matériau diélectrique (20) du substrat par cosublimation simultanée du semiconducteur moléculaire extrinsèque (30), formé d'une monophtalocyanine d'un métal divalent ou d'une monophtalocyanine hydrogénée, et du semiconducteur moléculaire intrinsèque (40), formé d'une phtalocyanine radicalaire.

8. Dispositif selon l'une des revendications 1 à 6, caractérisé par le fait que le revêtement (30, 40) est déposé sur la couche de matériau diélectrique (20) du substrat par sublimations consécutives du semiconducteur moléculaire extrinsèque (30), formé d'une monophtalocyanine d'un métal divalent ou d'une monophtalocyanine hydrogénée, et du semiconducteur moléculaire intrinsèque (40), formé d'une phtalocyanine radicalaire.

9. Dispositif selon la revendication 8, caractérisé par le fait que l'étape de sublimations consécutives du semiconducteur moléculaire extrinsèque (30) et du semiconducteur moléculaire intrinsèque (40), est suivie d'une étape de recuit pour favoriser le diffusion du semiconducteur moléculaire intrinsèque (40).

10. Dispositif selon l'une des revendications 1 à 9, caractérisé par le fait que le substrat est composé d'une couche de silicium (10) recouverte d'une couche de $SiO_2$ (20), cette dernière couche constituant la couche de matériau diélectrique.

11. Dispositif selon l'une des revendications 1 à 9, caractérisé par le fait que le substrat est composé d'une couche de silicium (1 0) recouverte d'une couche de Si3N4, cette dernière couche constituant la couche de matériau diélectrique.

**12.** Dispositif selon l'une des revendications 1 à 11, caractérisé par le fait que deux plages séparées de matériau électriquement conducteur (50, 60) sont déposées sur le revêtement (30,40).

**13.** Dispositif selon la revendication 12, caractérisé par le fait que les deux plages séparées de matériau électriquement conducteur (50, 60) déposées sur le revêtement (30, 40) servent de source et de drain, tandis qu'un contact pris sur la couche de matériau conducteur (10) du substrat sert de grille.

**14.** Dispositif selon l'une des revendications 1 à 13, caractérisé par le fait que le revêtement (30, 40) déposé sur la couche de matériau diélectrique (20) comprend une couche d'un semiconducteur moléculaire intrinsèque (40) formé d'une phtalocyanine radicalaire, qui possède une épaisseur inférieure à 1.10$^{-7}$m pour présenter un effet de champ.

**15.** Dispositif selon l'une des revendications 1 à 13, caractérisé par le fait que le revêtement (30, 40) déposé sur la couche de matériau diélectrique (20) comprend une couche d'un semiconducteur moléculaire intrinsèque (40) formé d'une phtalocyanine radicalaire qui possède une épaisseur supérieure à 1.10$^{-7}$ m pour présenter un comportement ohmique.

**16.** Dispositif selon l'une des revendications 1 à 15, caractérisé par le fait que le revêtement (30, 40) déposé sur la couche de matériau diélectrique (20), comprend une couche d'un semiconducteur extrinsèque (30) formé d'une monophtalocyanine d'une métal divalent ou d'une monophtalocyanine hydrogénée qui possède une épaisseur comprise entre 1.10$^{-7}$m et 5.10$^{-7}$m.

**17.** Dispositif à semiconducteur selon l'une des revendications 1 à 16, formant un transistor du type à effet de champ, caractérisé par le fait qu'il comprend :
- un substrat composé
. d'une couche (10) d'un matériau conducteur recouverte
. d'une couche (20) d'un matériau diélectrique,
- un revêtement déposé par évaporation sous vide sur la couche de matériau diélectrique et composé
. d'un semiconducteur moléculaire extrinsèque (30) formé d'une monophtalocyanine d'un métal divalent ou d'une monophtalocyanine huydrogénée, et
. d'un semiconducteur moléculaire intrinsèque (40) formé d'une phtalocyanine radicalaire, possédant une épaisseur inférieure à 1.10$^{-7}$m,
- deux plages séparées (50, 60) de matériau électriquement conducteur déposées sur le revêtement et servant respectivement de source et de drain, et
- un contact (70) pris sur la couche de matériau conducteur (10) du substrat, servant de grille.

FIG.1A

10

FIG.1B

20

FIG.1C

30

FIG.1D

40

FIG.1E

50

60

FIG.1

FIG_1

50

60

40

30

20

10

70

20'

FIG_2

FIG.3

FIG.4

FIG.6

# FIG_5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | TOUT L ELECTRONIQUE<br>no. 513, avril 1986, page 87, Paris, FR<br>* FET organique *<br>--- | 1,10,12<br>,13,17 | H 01 L 29/28 |
| A | EP-A-0 076 060 (ICI)<br>* page 4, ligne 10 - page 5, ligne 24;<br>page 8, ligne 29 - page 11, ligne 15;<br>exemple 5; figures 8a, 8b *<br>--- | 1,2,4,5<br>,14-17 | |
| D,A | SYNTHETIC METALS<br>tome 18, 1987, pages 683-688, Lausanne,<br>CH; J.J. ANDRE et al.: "Molecular<br>semiconductors and junction formation:<br>phtalocyanine derivatives" * en entier<br>*<br>--- | 1,2,7 | |
| A | US-A-4 164 431 (C.W. TANG)<br>* colonne 5, lignes 39 - 61; colonne 6,<br>lignes 31-39; exemple 1; figure 1 *<br>----- | 1 | |

DOMAINES TECHNIQUES
RECHERCHES (Int. Cl.4)

H 01 L 29/00

Le présent rapport a été établi pour toutes les revendications

| Lieu de la recherche | Date d'achèvement de la recherche | Examinateur |
|---|---|---|
| BERLIN | 31-02-1989 | ROUSSEL A T |